# EUROPÄISCHE PATENTANMELDUNG

(11) **EP 0 639 940 A1**
(43) Veröffentlichungstag der Anmeldung: **22.02.1995**
(21) Anmeldenummer: 94112087.5
(22) Anmeldetag: 03.08.1994
(51) Int. Cl.: H05K 9/00

(54) **Schaltungsanordnung für Kraftfahrzeuge**

(30) Priorität: 18.08.1993 DE 4327766
(71) Anmelder: Hella KG Hueck & Co., D-59552 Lippstadt (DE)
(72) Erfinder: Rehberg, Helmut, D-59555 Lippstadt (DE); Raulf, Manfred, D-59581 Warstein (DE); Klassen, Eugen, D-59556 Lippstadt (DE)

(57) **Zusammenfassung**

Bei einer Schaltungsanordnung für Kraftfahrzeuge mit einer elektrisch isolierenden Trägerplatte, mit auf der Trägerplatte angeordneten, Störpotential erzeugenden oder empfindlichen Bauteilen und mit auf der Trägerplatte angeordneten Leiterbahnen, die die Bauteile mit anderen Bauteilen elektrisch verbinden, sind die Bauteile zur einfachen und kostengünstigen Herstellung und zum Erreichen einer ausreichenden Abschirmung von einem oder mehreren Leiterbahnringen umgeben, die jeweils eine Unterbrechung aufweisen und gegeneinander versetzt sind. Diese Lösung ist sowohl mit als auch ohne Abschirmbehälter anwendbar.

## Beschreibung

Die Erfindung betrifft eine Schaltungsanordnung für Kraftfahrzeuge, nach dem Oberbegriff der Ansprüche 1, 3 und 5.

Derartige Schaltungsanordnungen werden zur Abschirmung Störpotential erzeugender oder Störpotential empfindlicher Bauteile von anderen Bauteilen und Schaltungsanordnungen verwendet, um Fehlfunktionen der Schaltungsanordnung aufgrund der Aussendung von Störpotential bzw. der Einstrahlung von Störpotential in Schaltungsanordnungen zu vermeiden. Bei den erzeugten Störpotentialen handelt es sich üblicherweise um elektromagnetische Hochfrequenzwellen, die zum Beispiel häufig von Mikrorechnerschaltungen erzeugt werden, die mit sehr hohen Taktfrequenzen bis zu 50 Megahertz arbeiten. Aufgrund der genannten hohen Taktfrequenzen, die zur Sicherstellung einer hohen Verarbeitungsgeschwindigkeit, insbesondere in Schaltungsanordnungen zur Motorsteuerung erforderlich sind, wird sowohl leitungsgebunden als auch leitungsungebunden Störpotential erzeugt, das andere Schaltungsanordnungen, wie zum Beispiel Rundfunkempfänger im Kraftfahrzeug stören kann.

Schaltungsanordnung nach den Oberbegriffen der Ansprüche 1, 3 und 5 sind aus der DE-OS 40 00 286 vorbekannt. Diese vorbekannte Schaltungsanordnung zeigt ein Abschirmbehältnis für einen Bereich einer Leiterplatte, das aus einem Abschirmbehälterdeckel und aus einem Abschirmbehälterboden besteht. Die elektrische und mechanische Verbindung der Abschirmbehälterteile erfolgt dabei durch Ausnehmungen der Leiterplatte hindurch, wobei die Ausnehmungen als Durchkontaktierungen im Bereich zweier Leiterbahnringe ausgebildet sind, die Massepotential aufweisen.

Einer dieser Leiterbahnringe weist eine Unterbrechung zur Durchführung von Leiterbahnen auf, die die Störpotential erzeugenden oder empfindlichen Bauteile mit anderen Bauteilen elektrisch verbinden.

Diese vorbekannte Schaltungsanordnung weist jedoch Nachteile auf. So wird in der DE-OS 40 00 286 grundsätzlich davon ausgegangen, daß zur notwendigen Abschirmung der Störpotential erzeugenden oder empfindlichen Bauteile ein derartiges Abschirmbehältnis, bestehend aus einem Abschirmbehälterdeckel und einem Abschirmbehälterboden, erforderlich ist. Derartige Abschirmbehälterteile sind jedoch nur zeit- und kostenaufwendig zu fertigen und verteuern den Aufbau derartiger Schaltungsanordnungen wesentlich. Zudem kann die mechanische Befestigung die Abschirmbehälterteile an der Leiterplatte bei den besonderen mechanischen Belastungen im Kraftfahrzeug zu Schwierigkeiten führen, was die Suche nach anderen oder vereinfachten Abschirmmöglichkeiten lohnenswert macht.

Selbst wenn, wie in der DE-OS 40 00 286 vorausgesetzt, ein Abschirmbehältnis erforderlich sein sollte, so ist hierzu nicht unbedingt ein mehrteiliges Abschirmbehältnis erforderlich, daß die Störpotential erzeugenden oder empfindlichen Bauteile vollständig umschließt. Jedes Teil, das eingespart werden kann, führt zu einer Verbilligung der Schaltungsanordnung und macht die Funktion der Schaltungsanordnung sicherer.

Die Erfindung hat die Aufgabe, Schaltungsanordnungen für Kraftfahrzeuge zu schaffen, die einfach und kostengünstig herstellbar sind und bei gegebenen Störpotentialverhältnissen eine ausreichende Abschirmung des Störpotentials ermöglichen.

Diese Aufgabe wird einerseits dadurch gelöst, daß die Bauteile nur von einem Leiterbahnring umgeben sind, der im Bereich der Leiterbahn eine Unterbrechung aufweist.

Versuche mit verschiedenen abzuschirmenden Bauteileanordnungen haben gezeigt, daß nicht in jedem Fall die Verwendung eines aufwendigen, vollständig geschlossenen Abschirmbehältnisses, wie im Stand der Technik vorgeschlagen, erforderlich ist. In den Fällen, in denen die Störpotentialaussendung nur geringfügig oberhalb vorgegebener Grenzwerte liegt, bzw. aufgrund zum Beispiel der vorhandenen Leiterbahnführung die Störpotentialaussendung auf kleine Bereiche der Trägerplatte begrenzt ist, kann es ausreichend sein, im Gegensatz zum vorbekannten Stand der Technik nur einen Leiterbahnring vorzusehen, der die Störpotential erzeugenden oder empfindlichen Bauteile umgibt. Diese erfindungsgemäße Lösung ist aufgrund des möglichen vollständigen Verzichtes auf ein Abschirmbehältnis besonders einfach und kostengünstig durchführbar.

Dabei weist der Leiterbahnring im Bereich der Leiterbahnen eine Unterbrechung auf, durch die die Leiterbahnen hindurchgeführt werden können, um die Störpotential erzeugenden oder empfindlichen Bauteile mit anderen Bauteilen elektrisch zu verbinden.

In diesem Zusammenhang kann auf der von dem Leiterbahnring abgewandten Seite der Trägerplatte eine Massefläche angeordnet sein, deren Umrisse den Umrissen des Leiterbahnringes entsprechen. Die Massefläche schirmt dann das Störpotential gegen die auf der anderen Seite der Trägerplatte angeordneten Bauteile ab.

Diese Maßnahme stellt auch bei Schaltungsanordnungen mit nur einem Abschirmbehälterdeckel gemäß dem Anspruch 3 eine weitere erfinderische Lösung der gestellten Aufgabe dar.

Durch die Anordnung, bestehend aus Abschirmbehälterdeckel und Massefläche, wird ein nahezu vollständig geschlossenes Abschirmbehältnis gebildet, wobei die Massefläche im wesentlichen dieselbe Funktion wie der Abschirmbehälterboden des Standes der Technik ausübt. Bei dieser erfindungsgemäßen Lösung wird also durch Verzicht auf einen Abschirmbehälterboden und durch das nahezu kostenneutrale Vorsehen einer Massefläche die erforderliche Abschirmung des Störpotentials erzielt. Dabei wird durch Verzicht auf den Abschirmbehälterboden ein gegenüber dem Vorbekannten wesentlicher Kostenvorteil erzielt. Die mit dieser erfindungsgemäßen Lösung erzielbare Abschirmwirkung ist für Schaltungsanordnungen mit im wesentlichen mittlerer Störpotentialerzeugung oder -empfindlichkeit durchaus ausreichend, wie Versuche ergeben haben.

Zur elektrischen und mechanischen Verbindung des Abschirmbehälterdeckels mit der übrigen Schaltungsanordnung kann in diesem Zusammenhang der Abschirmbehälterdeckel Lötkontaktfahnen aufweisen, die Durchkontaktierungen der Trägerplatte durchragen und mit der Massefläche verlötet sind. Mittels der Durchkontaktierungen weist dabei der Leiterbahnring dasselbe Potential auf wie die Massefläche. Dasselbe gilt durch die Verlötung für den Abschirmbehälterdeckel. Das heißt, alle drei genannten Teile weisen üblicherweise Massepotential auf.

Eine weitere Lösung der gestellten Aufgabe ergibt sich bei Verwendung des aus dem Stand der Technik vollständig bekannten Abschirmbehälters, bestehend aus Abschirmbehälterdeckel und Abschirmbehälterboden gemäß Anspruch 5 dadurch, daß beide Leiterbahnringe Unterbrechungen aufweisen, die gegeneinander axial versetzt sind.

Dadurch, daß beide Leiterbahnringe Unterbrechungen aufweisen, kann die Zahl der Leiterbahnen, die die Störpotential erzeugenden oder empfindlichen Bauteile mit anderen Bauteilen verbinden, wesentlich erhöht werden, ohne daß hierzu die erforderlichen Unterbrechungen nur eines Leiterbahnringes, wie aus dem Stand der Technik vorbekannt, besonders groß gewählt werden müßten. Mit diesen Maßnahmen kann die das Störpotential abschirmende Wirkung dieser Leiterbahnringe im Zusammenwirken mit den Abschirmbehälterteilen weitgehende vollständig aufrechterhalten werden.

Zur Verbesserung dieser Abschirmwirkung ist in diesem Zusammenhang erfindungsgemäß vorgesehen, daß die Unterbrechungen der beiden Leiterbahnringe gegeneinander axial versetzt angeordnet sind, so daß diese Unterbrechungen sich nicht auf den beiden Seiten der Trägerplatte gegenüberliegen. Durch diese Maßnahme wird ebenfalls vermieden, daß die erforderlichen Durchbrechungen oder Löcher des Abschirmbehältnisses eine Größe aufweisen müssen, die der elektromagnetischen Störstrahlung einen im wesentlichen ungehinderten Durchtritt ermöglicht. Zudem ist bei dieser erfindungsgemäßen Anordnung auch die beidseitige Bestückung der Trägerplatte mit Störpotential erzeugenden oder empfindlichen Bauteilen einfach möglich.

In diesem Zusammenhang können die Abschirmbehälterteile Lötkontaktfahnen aufweisen, die durch eine zweite Durchkontaktierung hindurchragen und mit den Leiterbahnringen verlötet sind. Mit diesen Maßnahmen wird sowohl die mechanische als auch die elektrische Verbindung der Abschirmbehälterteile mit den Leiterbahnringen gewährleistet. Dadurch weisen sowohl die Abschirmbehälterteile als auch die Leiterbahnringe dasselbe elektrische Potential auf.

Die erfindungsgemäßen Lösungen gemäß der Ansprüche 1, 3 und 5 können besonders vorteilhaft auch bei sogenannten Multilayerleiterplatten verwendet werden, bei denen die Trägerplatte mindestens vier leitfähige Schichten, Ebenen oder Lagen aufweist. In diesem Zusammenhang ist es besonders vorteilhaft, wenn eine durchgehende Masseebene und eine oder auch mehrere Versorgungsspannungsebenen vorgesehen sind, die innenliegend ausgebildet sind, so daß sie zwischen den Leiterschichten der Leiterbahnen auf beiden Außenseiten der Trägerplatte liegen.

In diesem Zusammenhang kann eine weitere positive Versorgungsspannungsebene durch eine ringförmige Freimachung von der anderen positiven Versorgungsspannungsebene getrennt werden. Dabei weist die eine innere Versorgungsspannungsebene mit den Abmessungen des Abschirmbehälters etwa entsprechende Außenabmessungen auf. Die elektrisch leitende Verbindung dieser inneren Versorgungsspannungsebene mit der sie umgebenden äußeren Versorgungsspannungsebene kann in diesem Zusammenhang besonders vorteilhaft direkt oder über eine andere Leiterschicht, nämlich über eine der beiden die Leiterbahnen tragenden Leiterschichten oder über die Masseebene erfolgen.

Um die Übermittlung leitungsgebundener Störpotentiale vom inneren der Leiterbahnringe zum äußeren der Leiterbahnringe und umgekehrt zu dämpfen, ist es bei allen erfindungsgemäßen Lösungen vorteilhaft, wenn Abblockkondensatoren vorgesehen sind, die die Leiterbahnen mit der Massefläche bzw. den üblicherweise Massepotential aufweisenden Leiterbahnringen verbinden. In diesem Zusammenhang können die Abblockkondensatoren besonders vorteilhaft innerhalb und außerhalb der Leiterbahnringe wechselweise angeordnet sein, um so bei vorgegebenen Außenabmessungen der Abblockkondensatoren die Dichte der Leiterbahnen im Bereich der Unterbrechungen erhöhen und damit deren Abstand entsprechend verringern zu können. Mit dieser Maßnahme kann nämlich die bei gegebener Zahl der Signalleiterbahn erforderliche Breite der Unterbrechung auf etwa die Hälfte reduziert werden, so daß die Abschirmwirkung weiter erhöht werden kann.

Wie vorher bereits mehrfach erwähnt ist es bei allen drei erfindungsgemäßen Lösungen besonders vorteilhaft, wenn der Leiterbahnring jeweils Massepotential aufweist, was sowohl die beanspruchte Beschaltung der Abblockkondensatoren ermöglicht als auch die Abschirmwirkung der Leiterbahnringe erhöht.

In der Masseebene können vorteilhaft Leiterbahnen isoliert eingelagert werden. Bei den eingelagerten Leiterbahnen kann es sich beispielsweise um die Verbindungsleitung zwischen den beiden positiven Versorgungsspannungsebenen handeln. Es kann sich auch um andere Leiterbahnen handeln, die zumindest teilweise außerhalb der Außenschichten der Trägerplatte geführt werden.

Ausführungsbeispiele der erfindungsgemäßen Schaltungsanordnungen sind in den Zeichnungen dargestellt und werden im folgenden anhand der Zeichnungen näher erläutert.

Es zeigen
- Figur 1: eine Schaltungsanordnung nur mit einem unterbrochenen Leiterbahnring;
- Figur 2: die Schaltungsanordnung gemäß Figur 1 ergänzt um eine Massefläche und Abblockkondensatoren;
- Figur 3: eine Schaltungsanordnung nur mit einem Abschirmbehälterdeckel und mit einer Massefläche;
- Figur 4: eine Schaltungsanordnung mit zwei Leiterbahnringen, deren Unterbrechungen gegeneinander axial versetzt sind;
- Figur 5: die Schaltungsanordnung gemäß Figur 4 ergänzt um einen Abschirmbehälterdeckel und einen Abschirmbehälterboden;
- Figur 6: eine andere Ansicht der Schaltungsanordnung gemäß Figur 5;
- Figur 7: ein Detail der Schaltungsanordnung aus Figur 6;
- Figur 8: einen Leiterbahnring mit daran angeordneten Abblockkondensatoren;
- Figur 9: eine Ansicht auf den dem Leiterbahnring aus Figur 8 auf der Trägerplatte gegenüberliegenden Leiterbahnring mit Unterbrechung;
- Figur 10: den grundsätzlichen Aufbau einer Multilayerleiterplatte;
- Figur 11: eine Schaltungsanordnung mit einer Multilayerleiterplatte gemäß Figur 10 und
- Figur 12: eine Leiterschicht der Multilayerleiterplatte gemäß Figur 10, die zwei positive Versorgungsspannungsebenen aufweist.

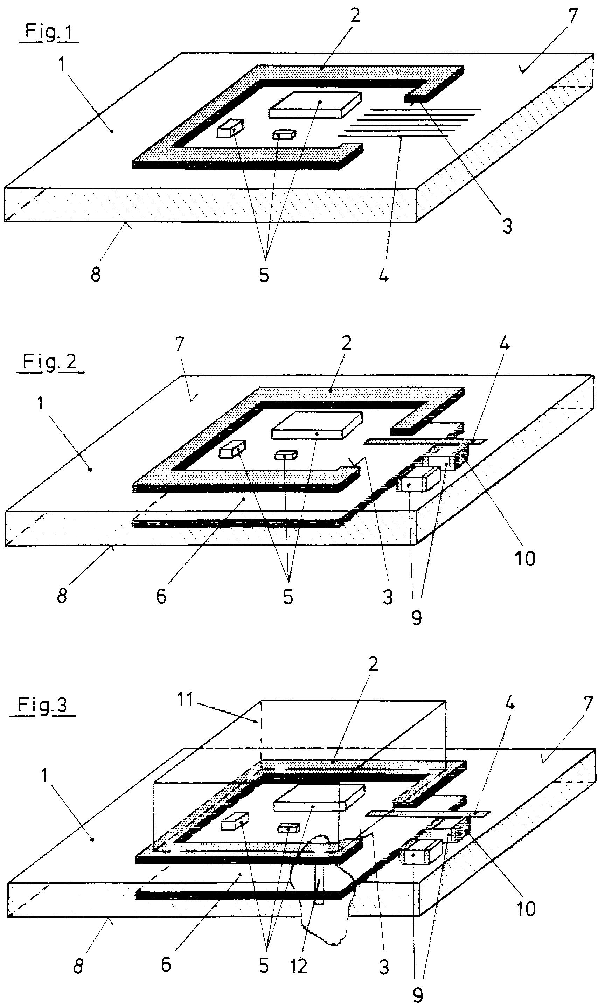

In der Figur 1 ist eine Leiterplatte (1) mit einem Massepotential aufweisenden Leiterbahnring (2) versehen, der im Bereich mehrerer Signalleiterbahnen (4) eine Unterbrechung (3) aufweist. Innerhalb des Leiterbahnringes (2) sind Störpotential erzeugende bzw. empfindliche Bauteile (5) angeordnet, die mittels der Signalleiterbahnen (4) mit weiteren Bauteilen außerhalb des Leiterbahnringes (2) elektrisch verbunden sind. Diese gesamte Anordnung befindet sich auf der Oberseite (7) der Trägerplatte (1), auf deren Unterseite (8) in der Figur 1 keine weiteren Maßnahmen durchgeführt wurden.

In dieser Figur 1 entkoppelt allein der Leiterbahnring (2) ohne weitere abschirmende Maßnahmen, wie z. B. Abschirmbehälter oder Teile davon, die Bauteile (5) derart von der Umgebung, daß ihre Funktion weder durch Störpotential von außen gestört wird noch diese Bauteile (5) andere außerhalb des Leiterbahnringes (2) befindliche Bauteile durch von ihnen selbst erzeugtes Störpotential ausreichend stören können. Dies stellt die einfachste Ausführungsform der erfindungsgemäßen Lösung dar, die in Einzelfällen bereits eine ausreichende Reduzierung als Störpotential erbringt.

In der Figur 2 sind gleiche oder gleichwirkende Einrichtungsteile wie in der Figur 1 mit den gleichen Bezugszeichen versehen. Hier weist die Anordnung gemäß der Figur 1 zusätzlich eine Massefläche (6) auf, die auf der Unterseite (8) der Trägerplatte (1) angeordnet ist und deren Außenabmessungen den Außenabmessungen des Leiterbahnringes (2) entsprechen. Die Massefläche (6) ist jeweils mit einem Anschluß eines Abblockkondensators (9) auf der Unterseite (8) der Trägerplatte (1) verlötet, der in der Figur 1 als SMD-Bauteil, das heißt als surface-mounted device ausgebildet ist. Der andere Anschluß der SMD-Abblockkondensatoren (9) ist über Durchkontaktierungen (10) mit den Leiterbahnen (4) leitend verbunden, um die Übertragung leitungsgebundender Störpotentiale über die Leiterbahnen (4) zu dämpfen. Die Massefläche (6) wirkt als Abschirmfläche der Störsignale von und zu den auf der Oberseite (7) angeordneten elektronischen Bauteilen (5) gegenüber der Umgebung unterhalb der Unterseite (8) der Träger- oder Leiterplatte (1). Die Massefläche wirkt auch als Ausgleichspotential.

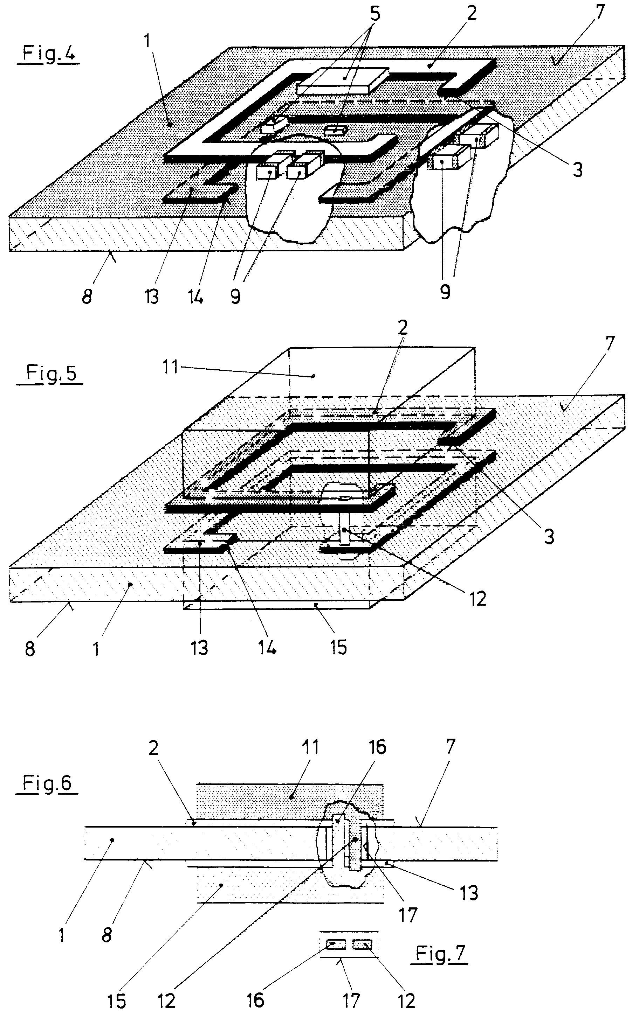

In der Figur 3 sind gleiche oder gleichwirkende Einrichtungsteile wie in den Figuren 1 und 2 mit den gleichen Bezugszeichen versehen. Hier ist zusätzlich zu den aus den genannten Figuren bekannten Merkmalen ein Abschirmbehälterdeckel (11) vorgesehen, der Lötkontaktfahnen (12) aufweist. Diese Lötkontaktfahnen sind durch Durchkontaktierungslöcher, wie zum Beispiel von den Durchkontaktierungen (10) bekannt, hindurchgesteckt und auf der vom Abschirmbehälterdeckel (11) abgewandten Seite mit der Massefläche (6) auf der Unterseite (8) der Trägerplatte (1) verlötet, so daß der Abschirmbehälterdeckel (11) wie die Massefläche Massepotential aufweist.

Bei dieser Anordnung gemäß Figur 3 bildet der Abschirmbehälterdeckel (11) gemeinsam mit der Massefläche (6) einen nahezu geschlossenen Abschirmbehälter, der nur im Bereich der Trägerplatte (1) und im Bereich der Unterbrechung (3) des Leiterbahnringes (2) Durchbrüche aufweist, durch die hindurch Störpotential zum Beispiel in Form von elektromagnetischen Hochfrequenzwellen hindurchtreten kann. Aufgrund der üblicherweise geringen Dicke der Trägerplatte (1) von etwa zwei Millimetern und der üblicherweise geringen Breite der Unterbrechung (3) ist diese Möglichkeit der Störpotentialübertragung jedoch eingeschränkt. Mit dieser Anordnung gemäß der Figur 3 wurden in Versuchen auch bei Schaltungsanordnungen mit mittlerer Störpotentialerzeugung bzw. -empfindlichkeit gute Abschirmergebnisse erzielt, die die Schaltungsanordnung für die Verwendung in Kraftfahrzeugen brauchbar macht.

In der Figur 4 sind gleiche und gleichwirkende Einrichtungsteile wie in den Figuren 1 bis 3 mit den gleichen Bezugszeichen versehen. Man erkennt hier eine Anordnung bei der auf beiden Seiten (7, 8) der Trägerplatte (1) Leiterbahnringe (2, 13) vorgesehen sind, die vorzugsweise Massepotential aufweisen. Auch der dortige zweite Leiterbahnring (13) weist eine zweite Unterbrechung (14) auf, durch die hindurch Signalleiterbahnen geführt werden, die in der Figur nicht dargestellt sind. Dabei ist die zweite Unterbrechung (14) gegenüber der ersten Unterbrechung (3) um einen Winkel von 90 Grad gegeneinander axial versetzt, um die sich gemeinsam mit der Dicke der Trägerplatte (1) ergebende Öffnung des Abschirmbehälters gemäß der später erläuterten Figur 5 so klein wie möglich zu halten. Es ist wesentlich vorteilhafter einen Abschirmbehälter mit mehreren kleinen Öffnungen als mit einer größeren Öffnung auszugestalten, weil der Durchtritt, insbesondere von hochfrequenten elektromagnetischen Wellen, stark von der Größe der Durchtrittsöffnung abhängig ist und mit größer werdenden Durchtrittsöffnungen drastisch zunimmt.

Weiterhin ist in der Figur 4 erkennbar, daß auf beiden Seiten (7, 8) der Trägerplatte (1) Abblockkondensatoren (9) vorgesehen sind, die jeweils mit den ihnen zugeordneten Leiterbahnringen (2, 13) im Sinne der Figuren 2 und 3 elektrisch leitend verbunden sind, um leitungsgebundene Störpotentiale zu dämpfen.

In der Figur 5 sind ebenfalls gleiche und gleichwirkende Einrichtungsteile wie in den Figuren 1 bis 4 mit den gleichen Bezugszeichen versehen. Man erkennt, daß ausgehend von einer Schaltungsanordnung gemäß der Figur 4 weiterhin ein Abschirmbehälterdeckel (11) und zusätzlich ein Abschirmbehälterboden (15) vorgesehen ist, das heißt, bei der erfindungsgemäßen Anordnung gemäß der Figur 5 wird der Abschirmbehälter durch den Abschirmbehälterdeckel (11), den Abschirmbehälterboden (15) und die unterbrochenen Leiterbahnringe (2, 13) gebildet. Diese Anordnung ermöglicht einerseits die Abschirmung auch energiereicher Störpotentiale, wie sie insbesondere bei hochfrequent betriebenen Mikrorechner-Schaltungsanordnungen auftreten. Andererseits wird durch den vorgesehenen Abschirmbehälterboden auf der Unterseite (8) der Trägerplatte (1) ein zusätzlicher abgeschirmter Hohlraum geschaffen, in dem weitere hochfrequent bzw. Störpotential erzeugende bzw. empfindliche Bauteile (5) angeordnet werden können, um noch komplexere und damit Schaltungsanordnungen mit größerem Raumbedarf aufzubauen.

Die Figur 6, in der ebenfalls gleiche oder gleichwirkende Einrichtungsteile wie in den Figuren 1 bis 5 mit den gleichen Bezugszeichen versehen sind, wird in einer Seitenansicht deutlich, daß der Abschirmbehälterdeckel (11) eine erste Lötkontaktfahne (12) und der Abschirmbehälterboden (15) eine zweite Lötkontaktfahne (16) aufweist, die durch eine zweite, entsprechend breit ausgebildete Durchkontaktierungsöffnung (17) hindurchgesteckt sind. Die Abmessungen dieser zweiten Durchkontaktierung (17) werden auch in der Figur 7, die dieses Detail deutlicher darstellt, deutlich. Anschließend werden die Abschirmbehälterteile (11, 15) über ihre Lötkontaktfahnen (12, 16) mit den Leiterbahnringen (2, 13) derart, zum Beispiel in einem Schwallbad, verlötet, daß die Abschirmbehälterteile einerseits mechanisch fixiert und andererseits elektrisch leitend mit den Leiterbahnringen verbunden sind und insofern Massepotential aufweisen.

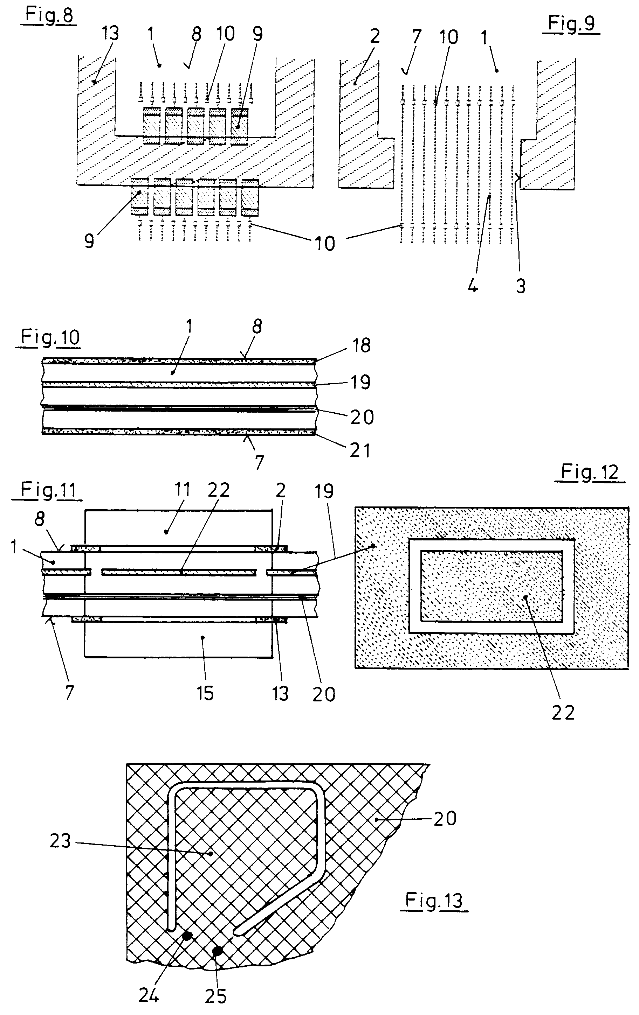

In der Figur 8 sind gleiche oder gleichwirkende Einrichtungsteile wie in den Figuren 1 bis 7 mit den gleichen Bezugszeichen versehen. Man erkennt in der Figur 8, daß die Abblockkondensatoren (9), die wiederum als SMD-Bauteile ausgebildet sind, innerhalb und außerhalb, in diesem Fall beispielweise des zweiten Leiterbahnringes (13), angeordnet sind. Die Anordnung erfolgt dabei zwischen den innerhalb und den außerhalb angeordneten Abblockkondensatoren (9) versetzt, so daß der Mittenabstand der Abblockkondensatoren (9) doppelt so groß sein kann, wie der Mittenabstand der Signalleiterbahnen (4) in der Figur 9, wie der dem in Figur 8 dargestellten zweiten Leiterbahnring (13) gegenüberliegenden Leiterbahnring (2) zeigt.

Auch in der Figur 9 sind gleiche oder gleichwirkende Einrichtungsteile wie in den Figuren 1 bis 8 mit denselben Bezugszeichen versehen. Die elektrische Verbindung des zweiten Leiterbahnringes (13) über die Abblockkondensatoren (9) mit den Signalleiterbahnen (4) erfolgt dabei durch die bereits vorher beschriebenen Durchkontaktierungen (10) in den Figuren 8 und 9. Durch die in den Figuren 8 und 9 beschriebene Anordnung der Abblockkondensatoren (9) kann der Mittenabstand der Leiterbahnen (4) wie erläutert halb so groß gewählt werden wie der Mittenabstand der Abblockkondensatoren (9), so daß zur Durchführung der Leiterbahnen (4) durch die Unterbrechung (3) nur etwa der halbe Platz erforderlich ist und insofern die Unterbrechnung nur halb so breit sein muß, als wenn alle Abblockkondensatoren auf einer Seite des zweiten Leiterbahnringes (13) angeordnet wären. Dies erhöht die Abschirmwirkung der Leiterbahnringe (2, 13) zusätzlich.

In der Figur 10 ist die Trägerplatte (1) als Multilayerleiterplatte ausgebildet, die an ihren Außenseiten (7, 8) zwei Leiterschichten (18, 21) zur Ausbildung von Leiterbahnen (4) aufweist. Die innenliegenden Leiterschichten sind als positive Versorgungsspannungsebene (19) und als Masseebene (20) ausgebildet.

Bei Aufbau einer erfindungsgemäßen Schaltungsanordnung mit einer derartigen Multilayerleiterplatte gemäß Figur 10 gelangt man zu der in Figur 11 dargestellten Anordnung bei der gleiche oder gleichwirkende Einrichtungsteile wie in den Figuren 1 bis 10 mit den gleichen Bezugszeichen versehen sind.

Neben den Abschirmbehälterteilen (11, 15) und den Leiterbahnringen (2, 13) ist erkennbar, daß im Bereich des sich ergebenden Abschirmbehälters die Masseebene (20) durchgehend und möglichst ohne Unterbrechung ausgebildet ist. Demgegenüber weist die positive Versorgungsspannungsschicht eine erste den Abschirmbehälter in etwa umgebende positive Versorgungsspannungsebene (19) auf, von der durch eine ringförmige Freimachung eine zweite Versorgungspannungsebene (22) abgetrennt ist, deren Außenabmessungen in etwa den Außenabmessungen des Abschirmbehälters entsprechen. Bis auf die beschriebene ringförmige Freimachung sind die Versorgungsspannungsebenen (19, 22) bis auf notwendige Durchbrechungen ausgebildet.

Damit die zweite positive Versorgungsspannungsebene (22) dasselbe Potential aufweist wie die erste positive Versorgungsspannungsebene (19) ist eine Kontaktierung erforderlich. Diese Kontaktierung erfolgt, in den Figuren nicht dargestellt, durch zwei Durchkontaktierungen zu einer der beiden Leiterschichten (18, 21) oder der Masseebene (20) vorzugsweise zur Leiterschicht (18) auf der Unterseite (8) der Trägerplatte (1) hin und durch ein entsprechendes kurzes Leiterbahnstück auf dieser Leiterschicht (18). Das heißt, die erforderliche Kontaktierung wird nicht in der Ebene der Versorgungsspannungsebene (19, 22), sondern außerhalb dieser Ebene geführt. Versuche haben ergeben, daß auch diese konstruktive Lösung zur Abschirmung von Störpotential beiträgt.

Wird die leitende Verbindungen der Ebenen (19, 22) über die Masseebene (20) hergestellt, so ist die zugehörige Leiterbahn, in den Figuren nicht dargestellt, in der Masseebene (20) isoliert einzulagern. Dies erbringt eine zusätzliche Minderung des Störpotentials durch Überkoppeln der Störung auf die Massefläche.

Entsprechend den zwei positiven Versorgungsspannungsebenen (19, 22) kann auch neben der Masseebene (20) eine zweite Masseebene (23) vorgesehen werden, die durch eine ringförmige Freimachung von der ersten Massenebene (20) getrennt und mit dem Abschirmbehälter (11, 15) etwa entsprechenden Abmessungen ausgebildet ist. Soll wie in der Figur 13 dargestellt die erforderliche leitende Verbindung zwischen den Masseebenen (20, 23) direkt erfolgen, so weist die zugehörige ringförmige Freimachung eine Unterbrechung auf, die diese leitende Verbindung bildet. Diese Lösung ist auch bei den Versorgungsspannungsebenen (19, 22) anwendbar. In diesem Fall kann die Massefläche (20) bzw. die zweite Massefläche (23) über die leitende Verbindung mit einem Anschluß eines Spannungsreglers (24) bzw. eines Massesteckers (25) großflächig leitend verbunden sein.

## Patentansprüche

1. Schaltungsanordnung für Kraftfahrzeuge, mit einer elektrisch isolierenden Trägerplatte (1), mit auf der Trägerplatte (1) angeordneten, Störpotential erzeugenden oder empfindlichen Bauteilen (5) und mit auf der Trägerplatte (1) angeordneten Leiterbahnen (4), die die Bauteile (5) mit anderen Bauteilen elektrisch verbinden, dadurch gekennzeichnet, daß die Bauteile (5) nur von einem Leiterbahnring (2) umgeben sind, der im Bereich der Leiterbahnen (4) eine Unterbrechung (3) aufweist.

2. Schaltungsanordnung nach Anspruch 1, dadurch gekennzeichnet, daß auf der von dem Leiterbahnring (2) abgewandten Seite der Trägerplatte (1) ein Massefläche (6) angeordnet ist, deren Umrisse den Umrissen des Leiterbahnringes (2) entspricht.

3. Schaltungsanordnung für Kraftfahrzeuge, mit einer elektrisch isolierenden Trägerplatte (1), mit auf der Trägerplatte (1) angeordneten, Störpotential erzeugenden oder empfindlichen Bauteilen (5), mit auf der Trägerplatte (1) angeordneten Leiterbahnen (4), die die Bauteile (5) mit anderen Bauteilen elektrisch verbinden, wobei die Bauteile (5) von einem Leiterbahnring (2) umgeben sind, der im Bereich der Leiterbahnen (4) eine Unterbrechung (3) aufweist, und mit einem Abschirmbehälterdeckel (11), der die Bauteile (5) umgibt, dadurch gekennzeichnet, daß auf der von dem Leiterbahnring (2) abgewandten Seite der Trägerplatte (1) eine Massefläche (6) angeordnet ist, deren Umrisse den Umrissen des Leiterbahnringes (2) entsprechen.

4. Schaltungsanordnung nach Anspruch 3, dadurch gekennzeichnet, daß der Abschirmbehälterdeckel (11) Lötkontaktfahnen (12) aufweist, die Durchkontaktierungen der Leiterplatte (1) durchragen und mit der Massefläche (6) verlötet sind.

5. Schaltungsanordnung für Kraftfahrzeuge mit einer elektrisch isolierenden Trägerplatte (1), mit auf der Trägerplatte (1) angeordneten, Störpotential erzeugenden oder empfindlichen Bauteilen (5), mit auf der Trägerplatte (1) angeordneten Leiterbahnen (4), die die Bauteile (5) mit anderen Bauteilen elektrisch verbinden, wobei die Bauteile (5) von zwei auf gegenüberliegenden Seiten der Trägerplatte (1) angeordneten Leiterbahnringen (2, 13) umgeben sind, von denen einer der Leiterbahnringe im Bereich der Leiterbahnen (4) eine Unterbrechung (3) aufweist, mit einem Abschirmbehälterdeckel (11), der die Bauteile (5) umgibt und mit einem Abschirmbhälterboden (15), der die Bauteile (5) umgibt, dadurch gekennzeichnet, daß beide Leiterbahnringe (2, 13) Unterbrechungen (3, 14) aufweisen, die gegeneinander axial versetzt sind.

6. Schaltungsanordnung nach Anspruch 5, dadurch gekennzeichnet, daß die Abschirmbehälterteile (11, 15) Lötkontaktfahnen (12, 16) aufweisen, die durch eine zweite Durchkontaktierung (17) hindurchragen und mit den Leiterbahnringen (2, 13) verlötet sind.

7. Schaltungsanordnung nach Anspruch 1, 3 oder 5, dadurch gekennzeichnet, daß die Trägerplatte (1) mindestens vier leitfähige Lagen (18 - 21) aufweist und daß eine Masseebene (20) und eine positive Versorgungsspannungsebene (19) innenliegend ausgebildet sind.

8. Schaltungsanordnung nach Anspruch 7, dadurch gekennzeichnet, daß eine weitere positive Versorgungsspannungsebene (22) durch eine ringförmige Freimachung von der anderen positiven Versorgungsspannungsebene (19) getrennt und mit dem Abschirmbehälter (11, 15) etwa entsprechenden Abmessungen ausgebildet ist und daß die leitende Verbindung dieser Ebenen (19, 22) direkt oder über eine andere Leiterschicht (18, 20, 21) hergestellt ist.

9. Schaltungsanordnung nach Anspruch 2, 3 oder 5, dadurch gekennzeichnet, daß Abblockkondensatoren (9) vorgesehen sind, die die Leiterbahnen (4) mit der Massefläche (6) bzw. den Leiterbahnringen (2, 13) verbindet.

10. Schaltungsanordnung nach Anspruch 9, dadurch gekennzeichnet, daß die Abblockkondensatoren (9) innerhalb und außerhalb der Leiterbahnringe (2, 13) wechselweise angeordnet sind.

11. Schaltungsanordnung nach Anspruch 1, 3 oder 5, dadurch gekennzeichnet, daß die Leiterbahnringe (2, 13) Massepotential aufweisen.

12. Schaltungsanordnung nach Anspruch 7, dadurch gekennzeichnet, daß in der Masseebene (20) Leiterbahnen isoliert eingelagert sind.
